# EUROPEAN PATENT APPLICATION

(11) **EP 2 228 809 A1**
(43) Date of publication of application: **15.09.2010**
(21) Application number: 09155051.7
(22) Date of filing: 12.03.2009
(51) Int. Cl.: H01G 9/00, H01L 51/05

(54) **Electronic device and method of manufacturing the same**

(71) Applicant: Nederlandse Organisatie voor Toegepast -Natuurwetenschappelijk Onderzoek TNO, 2628 VK Delft (NL)
(72) Inventor: Gelinck, Gerwin Hermanus, 5551 HT Valkenswaard (NL); Bressers, Petrus Marinus Martinus Cornelus, 5283 TP Boxtel (NL)
(74) Representative: Hatzmann, Martin

(57) **Abstract**

An electronic device is described including a transistor (90), comprising
- a first substrate (10) provided with a first electrically conductive layer (20),
- a second substrate (40) provided with a second electrically conductive layer (50) at a side that faces the semiconductor layer (30),
- at least one spacer (60) defining a space between the semiconductor layer (30) and the second electrically conductive layer (50),
- a liquid electrolyte (70) in said space.

## Description

### BACKGROUND

The field of organic electronics has progressed enormously in recent years. Advances have been made both in the fields of device science and fabrication as well as in the underlying Chemistry, Physics, and Materials Science. The impact of this field continues to influence many adjacent disciplines such as nanotechnology, sensors, and photonics. The advances in organic electronics have generated a vital and growing interest in organic materials research, and could potentially revolutionize future electronic applications. Organic field effect transistors, OFETs now routinely have mobilities >0.1 cm²/volt.sec, which is sufficient for many applications. This has been achieved for both p-channel and n-channel devices. Compared to inorganic FET, organic ones are unique in low-cost and flexibility. The perspective of organic FET's application and commercialization is largely subject to its cost-lowing The improved OFET devices have led to prototypes of electronic ID tags, electronic paper, and active matrix liquid crystal displays. There is also increasing interest in OFET-driven active matrix driven OLED/PLED displays.

Most common gate dielectrics used for the organic FETs are typically 100-500 nm thick inorganic oxides or polymer layers, whose capacitances are in the range of 5-30 nF/cm². With such relatively low capacitance, the maximum carrier density is limited in the order of 10¹³ cm⁻¹ even at the gate voltage *V_{G}* of 100 V, which is already close to dielectric breakdown. As one of the alternative methods to accumulate carriers more efficiently, there has been significant interest in making use of electrolytes. When *V_{G}* is applied to the electrolytes, electric double layers (EDLs) are formed after the ionic redistribution, so that *V_{G}* is sustained only at typically 1 nm thick EDLs. As the result, capacitance of the EDLs exceeds ∼10 µF/cm², meaning that orders of magnitude higher density carriers are accumulated at the surface of the semiconductors at the same *V_{G}* as compared to those in the SiO₂ organic FETs.

Recently, it has been demonstrated by several groups that the devices with polymer electrolytes are indeed successful for the high density carrier accumulation. A drawback of the polymer electrolytes, however, is their slow ionic diffusion before the EDL formation, which is actually fatal to the switching speed of the transistors. Moreover, many devices with polymer electrolytes suffer from serious deterioration in carrier mobility due to possible damages at the interface to the organic semiconductors, which reduces the merit of the EDL-FETs.

Ono et al describe rubrene single-crystal EDL-FETs with ionic liquids as an electrolyte in "High-mobility, low-power, and fast-switching organic field-effect transistors with ionic liquids", APPLIED PHYSICS LETTERS 92, 103313 _2008. Ionic liquids (IL)are also known as room-temperature molten salts. Without any solvent, ILs show distinctive properties of high thermal stability and no volatility, therefore attracting interests in the material properties themselves. The advantage of the ILs electrolyte in the OFETs is its high-speed formation of the EDLs; the rapid ionic diffusion of the ions typically in ∼1 µs is translated into 1-MHz-switching OFETs.

These devices were made by placing a droplet of IL electrolyte under a gold wire for a gate electrode on top of a rubrene single crystal to form the Au/IL electrolyte/rubrene single crystal/SiO₂/doped Si dual-gate structure. The gold wire is placed on the droplet in order to apply the gate voltage *V_{G}*, so that formation of the EDLs in the electrolyte can induce high-density carriers at the top surface of the crystal. The gate voltage across the SiO₂ gate insulator induces carriers at the bottom surface, and is used here only for control purposes and comparison.

This fabrication method has the disadvantage of a poor control over the thickness of the IL layer resulting in large device to device variation. Moreover, this way of manufacturing is not straightforward to implement in a mass production process. Furthermore it is not straightforward to integrate more than one transistor using interconnects.
US 2008191200A1 describes an ion gel including an ionic liquid and a block copolymer as the electrolyte. According to this prior art the semiconductor layer is deposited on the substrate, and a source electrode and a drain electrode are deposited on the semiconductor layer. The layer of ion gel is deposited on the semiconductor layer and the source electrode and the drain electrode to form the insulator layer. The gate electrode is subsequently deposited on the layer of ion gel. In the cited document use of a thermo reversible gel is proposed. Thermo reversibility allows an ion gel to be processed with a printing application at higher temperatures as a viscous liquid solution. When the gel is subsequently cooled to a lower use temperature, the ion gel is formed.

As the gel has liquid properties, it is difficult to control the shape of the features formed by the gel. This has a negative impact on the reproducibility of the devices manufactured with the method known from US 2008191200A1.

Accordingly there is a need for an efficient method to manufacture more reproducible electronic devices using a liquid electrolyte, e.g. as a gate dielectric. There is a further need to provide an electronic device that can be manufactured according to such a method.

### SUMMARY

According to a first aspect of the invention an electronic device is provided comprising
- a first substrate provided with a first electrically conductive layer,
- a second substrate provided with a second electrically conductive layer at a side that faces the semiconductor layer,
- at least one spacer defining a space between the semiconductor layer and the second electrically conductive layer,
- a liquid electrolyte in said space.

In the electronic device according to the invention the thickness of the liquid electrolyte is defined by the at least one spacer between the mutually laminated first and the second substrate. Accordingly the electrical properties of the electronic devices using the liquid electrolyte are well defined and therewith better reproducible.

The electronic device according to the invention can be manufactured by an efficient method according to a second aspect of the invention comprising the following steps:
- providing a first substrate,
- depositing a first electrically conductive layer at the first substrate,
- providing a second substrate,
- depositing a second electrically conductive layer at the second substrate,
- laminating the second substrate with the first substrate, with the second electrically conductive layer facing towards the layer of semiconductor material at the first substrate, wherein at least one spacer is arranged between the first and the second substrate for providing a space between the first and the second substrate,
- accommodating a liquid electrolyte in the space,
- sealing the space.

The method according to the invention is advantageous, as it allows for a separate manufacturing of different device structures on different substrates. Accordingly these partial manufacturing processes may be executed simultaneously. In case one of the semi-finished products of these partial manufacturing processes is defect, it suffices to reject only the defect semi-finished product instead of the end-product. In the process of laminating the thickness of the liquid electrolyte is determined by the substrates and the at least one spacer that is interposed between the substrates. The substrates may be of a rigid nature, so that the dimensions of the liquid electrolyte are fixed. Alternatively however, at least one of the substrates may be flexible, so that its shape can be controlled by forces exerted thereon. In that case the electronic device may serve as a sensor, e.g. a pressure sensor.

### BRIEF DESCRIPTION OF THE DRAWINGS

These and other aspects are described in more detail with reference to the drawing. Therein:
Figure 1A shows a first cross-section of a first exemplary embodiment of an electronic device according to the invention,
Figure 1B shows a second cross-section according to IB-IB in Figure 1A,
Figure 1C shows a third cross-section according to IC-IC in Figure 1A,
Figure 2A shows a first cross-section of a second exemplary embodiment of an electronic device according to the invention,
Figure 2B shows a second cross-section according to IIB-IIB in Figure 2A,
Figure 2C shows a third cross-section according to IIC-IIC in Figure 2A,
Figure 3 shows a method of manufacturing an electronic device according to the invention,
Figure 4A and 4B shows an aspect of a method for manufacturing an embodiment of an electronic device according to the invention,
Figure 5A and 5B shows an aspect of a method for manufacturing an embodiment of an electronic device according to the invention,
Figure 6A shows a first cross-section of a first exemplary embodiment of an electronic device according to the invention,
Figure 6B shows a second cross-section according to VIB-VIB in Figure 6A,
Figure 6C shows a third cross-section according to VIC-VIC in Figure 6A,
Figure 7 shows a single spacer in a further embodiment of a device according to the invention.

### DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art.

In the drawings, the size and relative sizes of layers and regions may be exaggerated for clarity. Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. Thus, the regions illustrated in the figures are schematic in nature and their shapes are not intended to illustrate the actual shape of a region of a device and are not intended to limit the scope of the invention.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. If a second layer is deposited on a first layer usually an interface layer is formed between said first and second layer. This interface layer can sometimes extend over a certain distance as a result of the processing conditions. Nevertheless, in this case the first and the second layer will be considered directly on each other.

Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein. In case of conflict, the present specification, including definitions, will control. In addition, the materials, methods, and examples are illustrative only and not intended to be limiting.

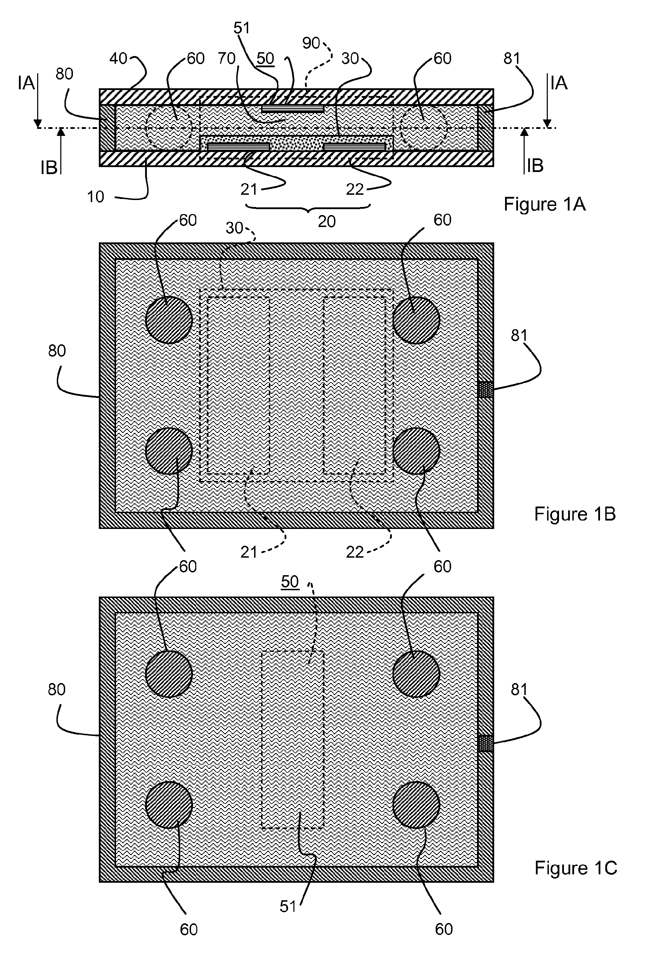

Figure 1A to 1C schematically show an exemplary embodiment of an electronic device according to the present invention. Therein Figure 1A shows a first cross-section. Figure 1B shows a second cross-section according to IB-IB in Figure 1A and Figure 1C shows a third cross-section according to IC-IC in Figure 1A.

The electronic device shown in Figure 1A-1C comprises a first substrate 10 that is provided with a first electrically conductive layer 20. The first electrically conductive layer 20 is patterned to form a source electrode 21 and a drain electrode 22. A semiconductor layer 30 is applied at the first electrically conductive layer 20. In particular the semiconductor layer 30 forms a semi-conductive path between the source 21 and the drain 22 electrode. The electronic device comprises a second substrate 40 that is provided with a second electrically conductive layer 50 at a side that faces the layer of semiconductor material. The first and the second substrate 10, 40 are laminated using a ring shaped structure 80. The ring shaped structure of sealing material 80 is closed by a closure 81. Both the ring shaped structure 80 and the closure 81 are preferably made of an adhesive that were hardened by a UV-treatment. The second electrically conductive layer 50 at the second substrate is patterned to form a gate electrode 51. Spacers 60 are present that define a space between the semiconductor layer 30 and the second electrically conductive layer 50. In the embodiment shown the spacers 60 are glass beads that are arranged between the first and the second substrate 10, 40. The spacers may be arranged otherwise, e.g. between the first electrically conductive layer or the layer of semiconductor material on the one side and the second electrically conductive layer on the other side. Likewise other shapes or materials may be used for the at least one spacer as long as a space is created between the layer of semiconductor material and the second electrically conductive layer. For example polymer materials may be used for the spacers and the spacers may for example be cylindrically or spherically shaped. A liquid electrolyte, in particular an ionic liquid 70 is arranged in the space defined by the spacers. A transistor 90 is formed by the source and drain electrode 21, 22, the gate electrode 51, the semiconductor layer 30 and the dielectric layer formed by the ionic liquid 70 in the space. An ionic liquid is a liquid formed of a salt that is liquid under the process conditions, such as a melt of a salt; thus the temperature and pressure under processing conditions are such that the salt *per se* is in a liquid state of matter. In general an ionic liquid used in a method of the invention, has a melting point below 200 °C, preferably of 100 °C or less, in particular of 50 °C or less. It is in particular preferred that the ionic liquid is liquid at about 20 °C or at about 25 °C. Such liquid may be referred to as a room temperature liquid salt.

In an embodiment, the ionic liquid comprises a salt of the following cations and/or anions:
- cations selected from the group of monosubstitued imidazolium compounds, disubstituted imidazolium compounds, trissubstitued imidazolium compounds, pyridinium compounds, pyrrolidinium compounds, phosphonium compounds, ammonium compounds, guanidinium compounds and isouronium compounds, including combinations thereof. The substituents may in particular be selected from the substituents described above, when referring to R¹-R⁵ in the amine salt of the formula R¹R²R³R⁴N⁺X⁻ (I).
- anions selected from the group of chloride, bromide, iodide, nitrate, nitrite, fluoride, phosphate, imide, amide, borate, tosylate, tetrafluoroborate, hexafluoroborate, hexafluorophosphate, trifluoromethanesulfonate, methylsulfate, bis(pentafluoroethyl)phosphinate, thiocynate, octylsulfate, hexylsulfate, buthylsulfate, ethylsulfate, dicyanamide, hexafluoroantimonate, bis-(pentafluoroethyl)phospinate, bis-(trifluoromethyl)imide, trifluoroacetate, bis-trifluorsulfonimide, triflate and dicyanamide, including combinations thereof.

The plating liquid may comprise a solvent, solvents being materials other than the liquid salt which are liquid under the conditions at which the method is carried out. In particular, the solvent may be chosen from inorganic solvents other than water and organic solvents.

Examples of particularly useful ionic liquids include 1-ethyl-3-methylimidazolium bis(trifluoromethylsulfonyl)imide ([EMIM] [TFSI]), 1-butyl-3-methylimidazolium hexafluorophosphate ([BMIM] [PF6]), and 1-ethyl-3-methylimidazolium n-octylsulfate ([EMIM] [OctSO4]).

In the embodiment shown in Figure 1A - 1C a transistor is formed. Various semiconductor materials are available, including inorganic semiconductors such as silicon, germanium, gallium arsenide. Organic semiconductors are for example semi-conductive oligomer or a semi-conductive polymer, or semiconductors including nanowires, nanoparticles, or films thereof. Exemplary organic semiconductors include, for example, pentacene, poyacetylene, polyaniline, and the like. Preferred organic semiconductors include poly(3-hexylthiophene) (P3HT), poly[5,5'-bis(3-dodecyl-2-thienyl)-2,2'-bithiophene] (PQT-12), and poly(9,9'-dioctylfluorene-co-bithophene) (F8T2). Although in principle any semiconductor material may be used, inorganic semiconductor materials are advantageous for achieving a long lifetime of the electronic device, in view of the slow diffusion of ionic liquids in these materials. Ionic liquids also show a slow diffusion in monocrystalline organic semiconductor materials. A rubrene crystal may for example be used as the semiconductor material.

Although Figure 1A - 1C show a transistor alternatively a capacitance may be formed using the liquid electrolyte by (a portion of) the first electrically conductive layer 20, the liquid electrolyte 70 and by (a portion of) the second electrically conductive layer 50.
The substrates 10, 40 may include a wide range of materials, including substantially rigid materials such as, for example, glass, silicon, and the like. In other embodiments, the substrate 10 and/or 40 may include flexible materials, such as a polymer or mixture of polymers. Suitable polymers are for example PET (Poly Ethylene Terephthalate) or PEN (Poly Ethylene Naphthalate) or PC (polycarbonate) layer. The substrate may for example have a thickness of less than 250 µm, e.g. 125 or 50 µm. Flexible substrates are generally preferred to facilitate continuous production processes using roll to roll techniques. The electronic properties of the electronic device having flexible substrates may be variable by exertion of external forces at the device, making it suitable as a sensor. During operation it provides an output signal that is dependent of the shape of the at least one flexible substrate.

Also in the case that the electronic device forms a sensor, the steady state values of its electronic properties, however, are still reproducible, as the at least one spacer 60 laminated between the substrates 10, 40 defines the dimensions of the ionic liquid in an unloaded state.

As the material for the electrically conductive layers 20, 50 any suitable conductive material, including gold, silver, copper, conductive alloys and conductive polymers may be used.

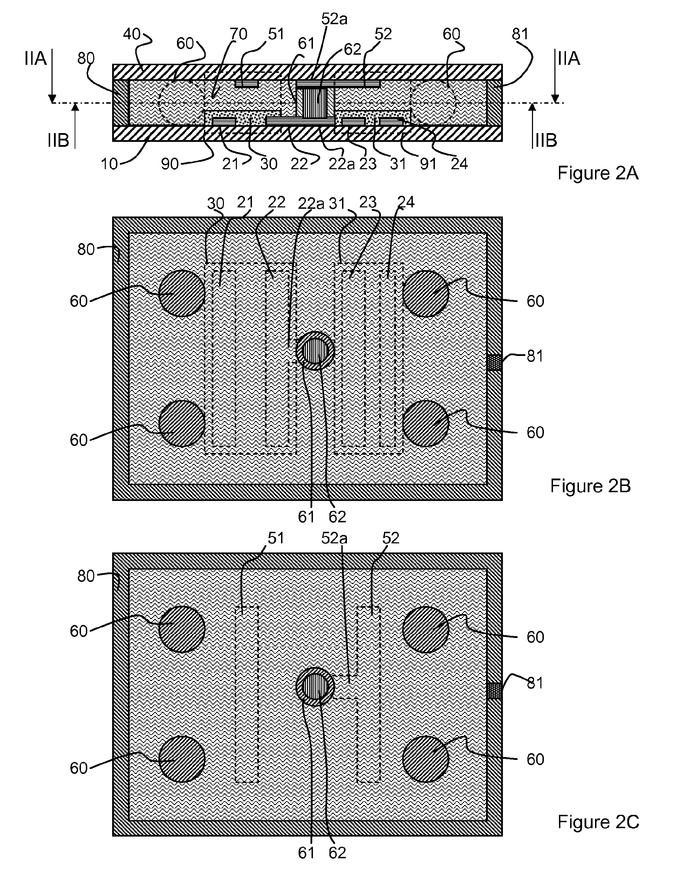

Figure 2A to 2C schematically show a further exemplary embodiment of an electronic device according to the present invention. Therein Figure 2A shows a first cross-section. Figure 2B shows a second cross-section according to IIB-IIB in Figure 2A and Figure 2C shows a third cross-section according to IIC-IIC in Figure 2A.

In the embodiment of Figure 2, the device comprises a further transistor 91 that is formed by a further gate electrode 52, a dielectric layer formed by the ionic liquid 70, a semiconductor layer 31 and a further source and drain electrode 23, 24. In the embodiment shown the drain 22 of the transistor 90 is electrically coupled to the further gate electrode 52. More in particular the drain electrode 22 of the transistor 90 has an extension 22a that is coupled via an electric conductor 62 to an extension 52a of the further gate electrode 52. The electric conductor 62 is surrounded by an insulating tube 61 that forms a spacer. The insulating tube 61 may be formed by a photolithographic method known as such. The electric conductor is for example a conductive glue or a conductive material applied in a solution or a suspension that is deposited in the tube 61 before lamination of the substrates 10, 40. A suitable conductive material comprises for example metal nano particles, e.g. silver nano particles or a conductive polymers such as PEDOT. The conductive glue is for example a silverpaste. For clarity, Figures 2A - 2C show only a very simple circuit having only 2 transistors 90, 91 and a single interconnection between the first and the second electrically conductive layer. It will be clear, however, that arbitrary complex circuits can be manufactured in this way.

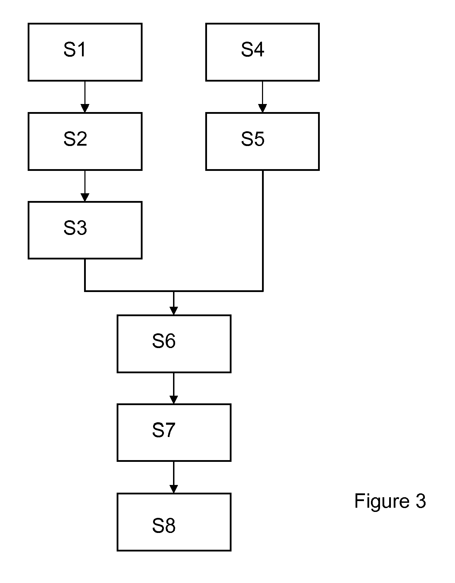

In the embodiment shown in Figure 2, the tube 61 may for example have an inner diameter of about 20 to 50 µm, e.g. 30 µm and wall thickness in the range of 5 to 20 µm, e.g. 10 µm.
The electronic device shown in Figure 1A - 1C and the electronic device of Figure 2A - 2C can be manufactured by a method according to the invention as described with reference to Figure 3.
In a first step S1 of the method for manufacturing an electronic device according to the invention a first substrate is provided. In a second step S2 a first electrically conductive layer is deposited at the first substrate. The first electrically conductive layer may be patterned to form a source and a drain electrode. The layer may be patterned for example when it is applied, e.g. with a printing process, or the first electrically conductive layer may be patterned after it is applied, e.g. by a lithographic process. Subsequently, in a third step a layer of semiconductor material or precursor thereof is deposited at the first electrically conductive layer.
In a fourth step S4 of the method a second substrate is provided. Subsequently, in a fifth step a second electrically conductive layer is deposited at the second substrate. In a sixth step S6 the second substrate is laminated with the first substrate, with the second electrically conductive layer facing towards the layer of semiconductor material at the first substrate. At least one spacer is arranged between the first and the second substrate for providing a space between the first and the second substrate.

The spacers, for example plastic or glass spheres, may be deposited with methods known from LCD-manufacturing processes. According to one of such methods the spacers are suspended in a liquid and spincoating over the surface formed by a substrate or by a layer thereon, after which the liquid is evaporated. Alternatively the spacers may be formed photolithographically on top of one (or both) substrates.

In a seventh step S7 an ionic liquid is accommodated in the space and the space is subsequently sealed in an eighth step S8.

Steps S4 and S5 may take place simultaneously and independently from steps S1 - S3. This is advantageous for an efficient manufacturing process. The semi finished products obtained with the steps S1-S3 on the one hand and the steps S4 - S5 on the other hand may be tested independently before they are used for manufacturing the electronic device with steps S6-S8.

Several options are possible to accommodate the ionic liquid in the space. According to a first embodiment of the method the space between the first and the second substrate is partially sealed when the substrates are laminated. This may be realized by coupling the substrates with an adhesive. Preferably an UV-curable adhesive is used. However an opening is left in the sealing that communicates with the space. After curing the adhesive the ionic liquid is then accommodated in the space by providing the ionic liquid via the opening. The ionic liquid may subsequently distribute all over the space by capillairy flow. To enable capillary flow the spacers preferably have a height, i.e. the size transverse to the plane of the substrates, that is at most 20 µm. For ease of manufacturing the diameter of the spacers is preferably at least 0.5µm. The speed with which the ionic liquid flows into the space may be enhanced by evacuating the space between the first and second substrate prior to the step of providing the ionic liquid is evacuated. The ionic liquid may be provided in a chamber having an overpressure, e.g. of air or N2 so that the ionic liquid is forced into the space. Alternatively, a second opening may be provided in the sealing that allows gases to escape from the space while the ionic liquid enters the space. The flow of ionic liquid into the space may also be enhanced by heating the ionic liquid in advance. Once the ionic liquid is accommodated in the space the opening(s) is (are) closed. For example the openings are filled with a amount of UV-curable adhesive,

According to another embodiment the ionic liquid is applied at one of the substrates before the substrates are laminated. The ionic liquid may for example be provided at the semiconductor layer of the first substrate or at the second electrically conductive layer of the second substrate, for example by spinning the ionic liquid. The substrates may be glued together by an adhesive, e.g. a UV-curable adhesive. In this embodiment the spacers may also have a larger height than the preferred maximum height of 20 µm indicated for the first embodiment of the method.

In particular in the first embodiment of the method according to the invention it may be advantageous to heat the ionic liquid or other liquid electrolyte before carrying out step S7. In this way the viscosity of the liquid electrolyte is lowered, so that it flows more rapidly to the space between the substrates reserved therefore. Likewise, in the second embodiment of the method, the liquid electrolyte will more rapidly wet the surface of the substrate where it is applied.

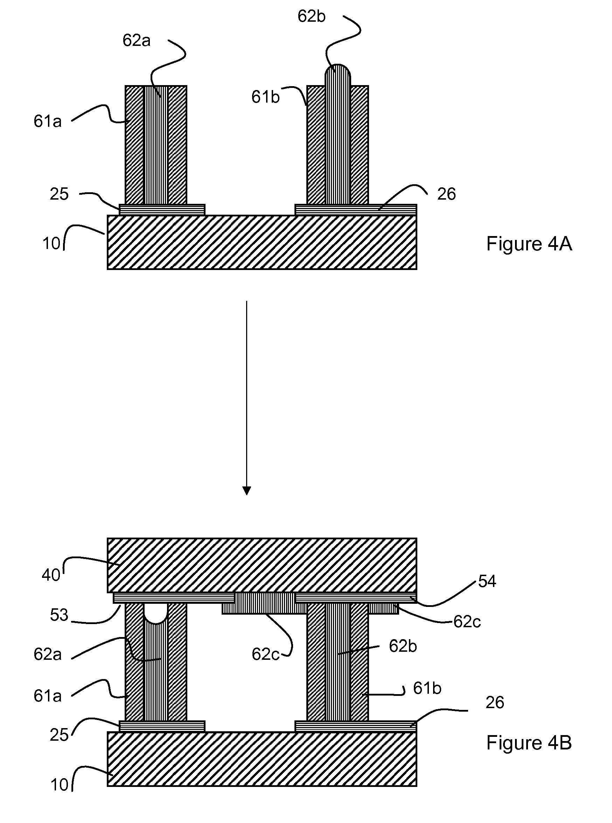

Figure 4A and 4B show that it is important that the conductive glue to be deposited in the tube 61 should be accurately dosed. Figure 4A schematically shows the first substrate with a first and a second tube 61a, 61b before lamination and Figure 4B show the situation after the first and the second substrate 10, 40 are laminated. In Figure 4A the tube 61a is provided with a relatively small dose of conductive paste 62a. In both cases the conductive glue contacts a an electric conductor 25, 26 at the lower substrate 10, as desired. As is seen in Figure 4B however, it may happen that a part of the suspension of the paste 62a is lost, e.g. due to evaporation so that after lamination there is an insufficient contact of the conductive paste 62a with a portion 53 of the second electrically conductive layer. On the other hand if a too large amount of conductive paste 62b is dosed, as in the tube 61b, conductive paste 62c may be forced outside the tube 62b and even cause an unwanted electric connection e.g. between portions 53 and 54 of the second electrically conductive layer. Accordingly an amount of conductive paste should be dosed that accurately takes into account the volume loss until lamination. Alternatively a relative large distance may be provided between the elements formed in the second electrically conductive layer so that a certain amount of overflow can be tolerated.

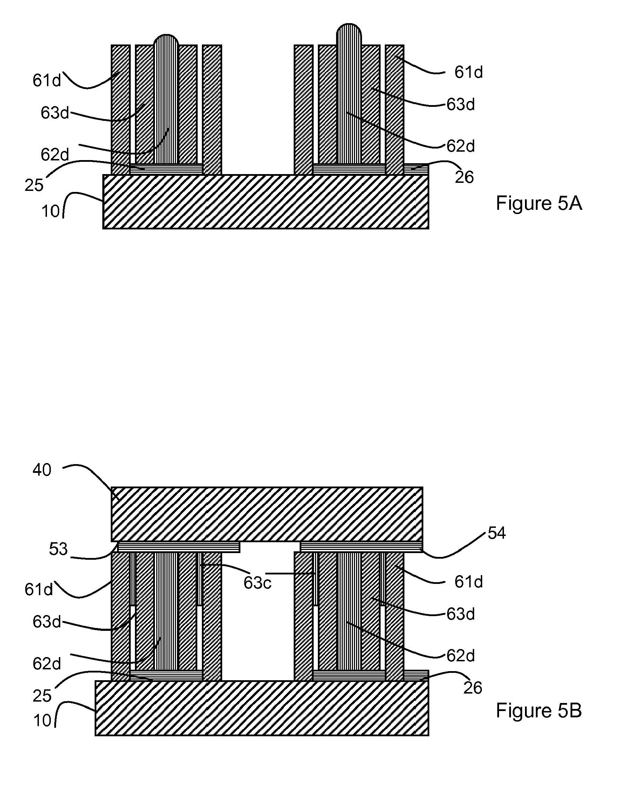

In an advantageous embodiment according to the invention the electric conductor 62d is arranged within a further tube 63d that is surrounded with space by the insulating tube 62d. It can be seen in Figures 5A and 5B that in this arrangement the dose of the conductive paste 62d forming the electric conductor is not critical. An excessive dose of the conductive paste may be provided as shown in the left and right hand side of Figure 5A. After lamination of the substrates 10, 40 the excess of conductive paste 63c flows into the space enclosed between the tubes 63d and 61d and therewith causes no malfunction. The further tube 63d may be either conductive or non-conductive. If the further tube 63d is non-conductive it may be manufactured from the same material as the tube 61d, which is advantageous. If the further tube 63d is conductive it may support the conductive function of the electric conductor formed by the conductive paste 62d, which is also advantageous.

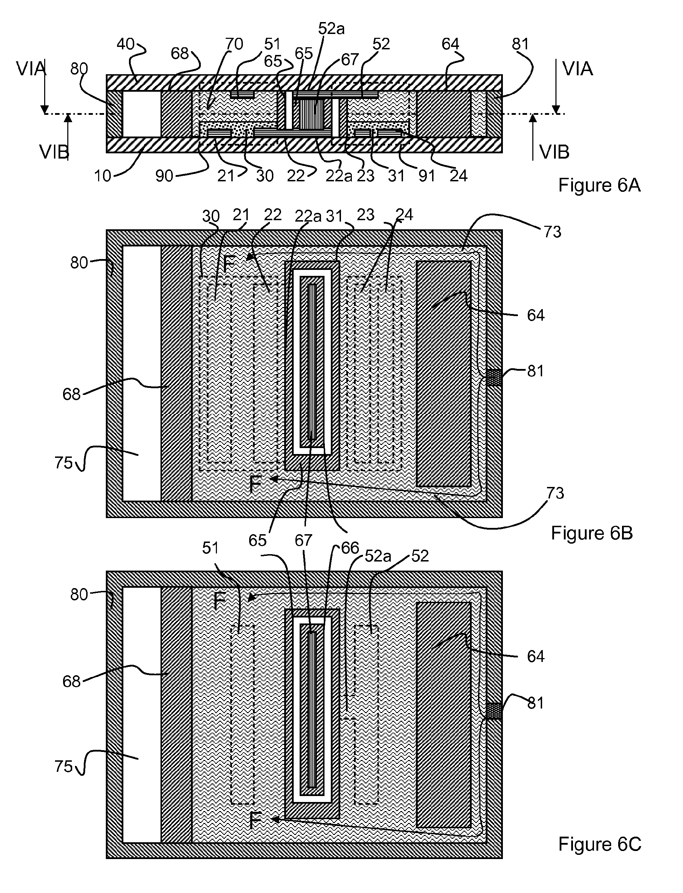

Figures 6A to 6C show a further embodiment of the electronic device according to the invention. The embodiment shown in Figures 6A-6C differs from the embodiments 1A-C and 2A-C in that relatively large spacers are applied. This results in a large mechanical strength of the device. In particular elongated spacers 64, 65, 68 with an elongated shape are arranged between the first and the second substrate 10, 40. In the embodiment shown a first ribbon-like spacer 64 has a length that is less than the width of the substrates so that a gap between the substrates 10, 40 remains along the ends of the spacer. The gap provides for a channel 73 via which an ionic liquid 70 may flow inside the space between the substrates 10, 40 as indicated by arrows F. The ionic liquid 70 may be injected within the housing formed by the substrates 10, 40 by an opening in the sealing 80. The opening in the sealing 80 can be subsequently closed by a curable adhesive 81. The curable adhesive 81 is for example a heat or UV curable adhesive. The spacers 64, 65, 68 in the embodiment shown are rectangular. However, different shapes, e.g. curved shapes are possible. A second spacer is formed by an insulating tube 65 that surrounds an electric conductor 67. The electric conductor connects a portion 22a of the first electrically conductive layer 20 with a portion 52a of the second electrically conductive layer 50. The electric conductor 67 is arranged within a further tube 66 that is surrounded with space by the insulating tube 65. In the embodiment shown the tubes 66, 67 have a length (e.g. < 20 µm), i.e. their dimension transverse to the plane of the substrates, that is substantially shorter than their dimensions within the plane of the substrates. Hence, the tubes 65, 66 may be considered as rings around the conductor 67. The tubes or rings 65, 66 are not necessarily of the same shape. For example, the inner ring or tube 66 may have a circular shape, while the outer tube or ring 65 has an elongated shape, e.g. in the form of an ellipse. In an embodiment an inner tube or ring may be absent, so that the conductor is directly enclosed by the tube 65.
In the embodiment shown the electronic device has a further spacer 68 that separates a space 75 from the remaining space between the substrates 10, 40. When filling the space between the substrates 10, 40 with a liquid electrolyte 70, such as an ionic liquid, the separated space 75 remains free from the electrolyte 70. Accordingly zones can be created between the first and the second substrate 10, 40 that merely contain air or an inert gas, having a low dielectrical constant and therewith a small electrical coupling between the substrates.

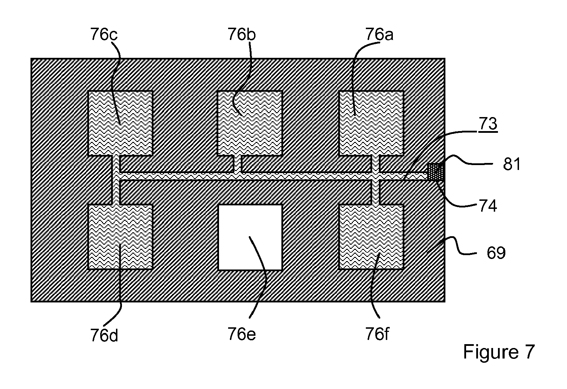

In an embodiment of the electronic device according to the present invention a single spacer 69 may define the space where the liquid electrolyte is present and the space that is free from liquid electrolyte, e.g. filled with air or nitrogen. This is illustrated with reference to Figure 7. The spacer defines six chambers 76a, ..., 76f. Five thereof communicate with a system of channels 73. Only chamber 76e is isolated from this system 73. If an end 74 of the system of channels 73 is applied to a vacuum connection, or the assembly comprising the spacer 69 and the substrates between which it is sandwiched is arranged in a vacuum then the chambers 76a, ..., 76d and 76f are evacuated via the system of channels 73. Chamber 76e is not evacuated. If a liquid electrolyte is provided at the end 74 of the system of channels 73 it flows via the system of channels 73 to each of the chambers 76a, ..., 76d and 76f. Chamber 76e remains free from the liquid electrolyte, and may for example contain air or another gas that entered therein before lamination. After filling the chambers 76a, ..., 76d and 76f with the liquid electrolyte in this way, the end of the system of channels 73 is closed by a closure 81. Accordingly three types of zones are formed: Zones where a liquid electrolyte is present (the chambers 76a, ..., 76d and 76f), zones that are free from liquid electrolyte, but that may contain a gas or a mixture of gases (chamber 76e), and zones where the material from the spacer is present. It is noted that more than one system of channels may be provided in the at least on single spacer, so that different chambers may be provided with different liquid electrolytes.

It will be understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.
Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

## Claims

1. Method for manufacturing an electronic device comprising,
- providing (S1) a first substrate,
- depositing (S2) a first electrically conductive layer at the first substrate,
- providing (S4) a second substrate,
- depositing (S5) a second electrically conductive layer at the second substrate,
- laminating (S6) the second substrate with the first substrate, with the second electrically conductive layer facing towards the layer of semiconductor material at the first substrate, wherein at least one spacer is arranged between the first and the second substrate for providing a space between the first and the second substrate,
- accommodating (S7) a liquid electrolyte in the space,
- sealing (S8) the space.

2. Method according to claim 1, further comprising the step of depositing (S3) a layer of semiconductor material or precursor thereof at the first electrically conductive layer.

3. Method according to claim 1, further comprising the steps of
- providing an opening that communicates with the space between the first and the second substrate,
- providing the liquid electrolyte via the opening after the step of laminating.

4. Method according to claim 3, wherein prior to the step of providing the liquid electrolyte the space between the first and second substrate is evacuated.

5. Method according to claim 1, wherein the liquid electrolyte is provided at one of the substrates before the first and the second substrate are laminated.

6. Method according to claim 1, wherein the liquid electrolyte is an ionic liquid.

7. Method according to claim 3, wherein the at least one spacer defines at least one channel that connects the opening with the space.

8. An electronic device comprising
- a first substrate (10) provided with a first electrically conductive layer (20),
- a second substrate (40) provided with a second electrically conductive layer (50) at a side that faces the semiconductor layer (30),
- at least one spacer (60) defining a space between the semiconductor layer (30) and the second electrically conductive layer (50),
- a liquid electrolyte (70) in said space.

9. An electronic device according to claim 8, further comprising a semiconductor layer (30) at the first electrically conductive layer (20),

10. An electronic device according to claim 8, wherein at least one of the spacers comprises an insulating tube (61) surrounding an electric conductor (62) that connects a portion (22a) of the first electrically conductive layer (20) with a portion (52a) of the second electrically conductive layer (50).

11. An electronic device according to claim 10, **characterized in that** the electric conductor (62d) is arranged within a further tube (63d) that is surrounded with space by the insulating tube (61d).

12. An electronic device according to claim 8, wherein the liquid electrolyte (70) is an ionic liquid.

13. An electronic device according to claim 8, wherein at least one of the first and the second substrate is flexible, the electronic device forming a sensor that during operation provides an output signal that is dependent of the shape of the at least one flexible substrate.

14. An electronic device according to claim 8, wherein the at least one spacer (68) separates a space (75) free from electrolyte (70) from the space containing the electrolyte.
